# EUROPEAN PATENT APPLICATION

(11) **EP 4 033 265 A1**
(43) Date of publication of application: **27.07.2022**
(21) Application number: 20866195.9
(22) Date of filing: 29.06.2020
(51) Int. Cl.: G01R 33/032, G01R 33/12

(54) **MAGNETIZATION MEASUREMENT DEVICE AND MAGNETIZATION MEASUREMENT METHOD**

(30) Priority: 20.09.2019 JP 2019171903
(71) Applicant: Showa Denko K.K., Tokyo 105-8518 (JP)
(72) Inventor: SHINO, Tatsunori, Ichihara-shi, Chiba 290-0067 (JP)
(74) Representative: Strehl Schübel-Hopf & Partner
(86) International application number: PCT/JP2020/025555
(87) International publication number: WO 2021/053925

(57) **Abstract**

A magnetization measurement device includes: a current supply part supplying a periodically changing current to a sample made of a soft magnetic material with uniaxial magnetic anisotropy in a first direction and a bias magnetic field applied in a second direction crossing the first direction; a light irradiation part irradiating a surface of the sample with linearly polarized pulse light having a predetermined delay time with respect to the current and having a predetermined polarized surface; and a measurement part measuring magnetization of the sample at the delay time based on reflected light of the pulse light reflected by the surface of the sample. These enable the measurement of the change in the magnetization of the sample over time, which corresponds to supply of the periodically changing current.

## Description

### Technical Field

The present invention relates to a magnetization measurement device and a magnetization measurement method.

### Background Art

As a conventional art, Patent Document 1 discloses a magnetization measurement method using a longitudinal Kerr effect. In the magnetization measurement method, a sample configured with a magnetic material film, etc., is irradiated with linearly polarized light emitted from a laser light source, and a light quantity of reflected light proportional to a rotational angle of a polarized surface corresponding to a magnitude of magnetization due to the Kerr effect is detected by a light quantity detector, to thereby measure the magnetization of the sample.

### Citation List

### Patent Literature

Patent Document 1: Japanese Patent Application Laid-Open Publication No. H06-308211

### Summary of Invention

### Technical Problem

By the way, in the case where a current that periodically changes, such as a pulse current, is supplied to a sample which has uniaxial magnetic anisotropy and to which a predetermined bias magnetic field is applied, the magnetization of the sample sometimes changes over time corresponding to the supply of the current.

An object of the present invention is to enable to measure change in magnetization of a sample over time, which corresponds to supply of a periodically changing current.

### Solution to Problem

A magnetization measurement device to which the present invention is applied includes: a current supply part supplying a periodically changing current to a sample made of a soft magnetic material with uniaxial magnetic anisotropy in a predetermined first direction and a bias magnetic field applied in a second direction crossing the first direction; a light irradiation part irradiating a surface of the sample with linearly polarized pulse light having a predetermined delay time with respect to the current and having a predetermined polarized surface; and a measurement part measuring magnetization of the sample at the delay time based on reflected light of the pulse light reflected by the surface of the sample.

Here, the current supply part supplies a pulse current having a predetermined repetition period to the sample.

Moreover, the light irradiation part emits the pulse light to cause an advancing direction of the pulse light that is to enter the sample and an advancing direction of the reflected light reflected by the surface of the sample to be in parallel with the first direction or the second direction.

From another standpoint, a magnetization measurement method to which the present invention is applied includes: supplying a periodically changing current to a sample made of a soft magnetic material with uniaxial magnetic anisotropy in a predetermined first direction and a bias magnetic field applied in a second direction crossing the first direction; irradiating a surface of the sample with linearly polarized pulse light having a predetermined delay time with respect to the current and having a predetermined polarized surface; and measuring magnetization of the sample at the delay time based on reflected light of the pulse light reflected by the surface of the sample.

### Advantageous Effects of Invention

According to the present invention, it is possible to measure the change in the magnetization of the sample over time, which corresponds to supply of the periodically changing current.

### Brief Description of Drawings

FIG. 1 is an overall view illustrating a magnetization measurement device to which the exemplary embodiment is applied;
FIGS. 2A and 2B are diagrams illustrating an example of a configuration of a magnetic sensor;
FIG. 3 is a diagram showing a relation between a magnetic field applied in the longitudinal direction of a sensitive element and change in the voltage generated when a pulse current is supplied to the magnetic sensor by a current supply part;
FIG. 4 is a schematic view showing change in magnetization of the sensitive element in the case where the pulse current is supplied;
FIG. 5 is a timing chart showing a relation between the pulse current supplied to the magnetic sensor by the current supply part and pulse light emitted to a surface of the sensitive element in the magnetic sensor by a pulse laser; and
FIG. 6 is a diagram showing an example of change in the magnetization in the sensitive element over time, which is obtained by combining results of the magnetization measured with different delay times of the pulse light.

### Description of Embodiment

Hereinafter, an exemplary embodiment according to the present invention will be described with reference to attached drawings.

### (Configuration of magnetization measurement device 1)

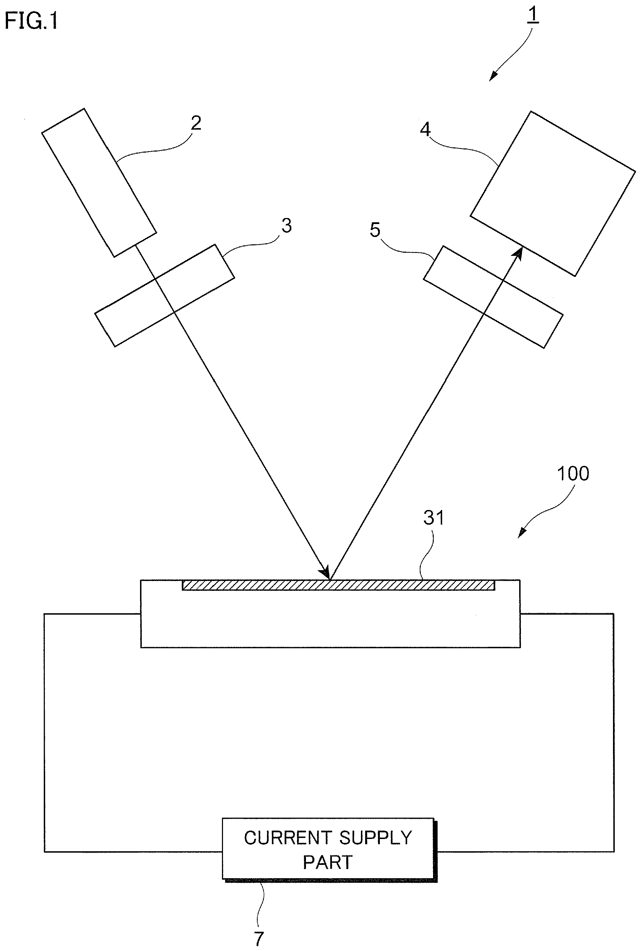

FIG. 1 is an overall view illustrating a magnetization measurement device 1 to which the exemplary embodiment is applied. The magnetization measurement device 1 performs time-resolved measurement of amount of change in magnetization in a sensitive element 31, etc., of a magnetic sensor 100. Note that the magnetic sensor 100, which is an object of measuring the magnetization by the magnetization measurement device 1, will be described in detail later.

The magnetization measurement device 1 includes: a pulse laser 2 that emits the pulse light toward the magnetic sensor 100; and a polarizer 3 that linearly polarizes the pulse light emitted from the pulse laser 2 to have a predetermined polarized surface. The magnetization measurement device 1 also includes: a detection device 4 that detects reflected light, which is light emitted from the pulse laser 2 and reflected by a surface of the magnetic sensor 100; and an analyzer 5 that transmits the reflected light with a predetermined polarized surface toward the detection device 4. The magnetization measurement device 1 further includes a current supply part 7 that supplies the pulse current to the magnetic sensor 100.

Though details will be described later, in the magnetization measurement device 1, the surface of the magnetic sensor 100 (more specifically, the sensitive element 31) is irradiated with the pulse light emitted from the pulse laser 2 via the polarizer 3. The polarized surface of the reflected light of the pulse light reflected on the surface of the sensitive element 31 is rotated by the magneto-optical Kerr effect in accordance with the state of the magnetization on the surface of the sensitive element 31, and the reflected light is incident on the detection device 4 via the analyzer 5. The detection device 4 measures the magnetization on the surface of the magnetic sensor 100 (the sensitive element 31) based on the result of detection of the reflected light.

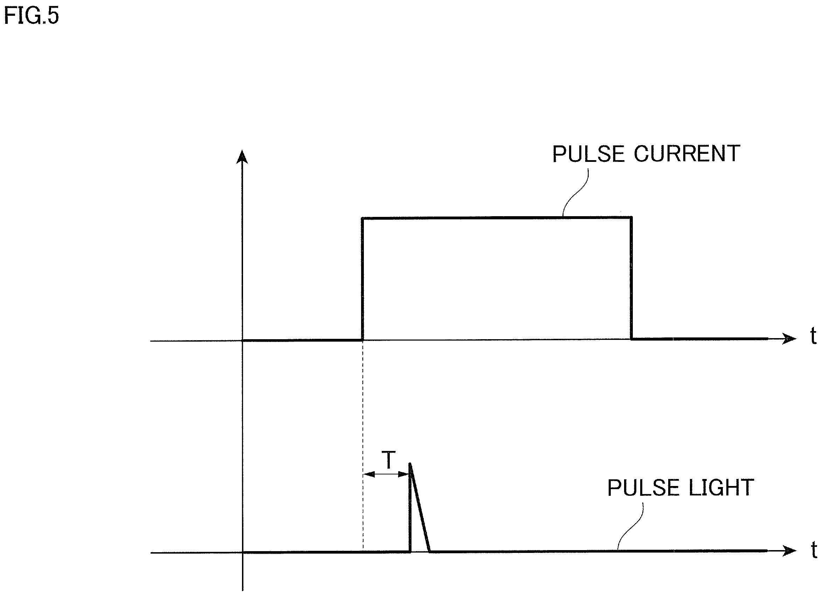

The pulse laser 2 emits the pulse light with a predetermined pulse width and wavelength toward the surface of the sensitive element 31 at a predetermined period. The oscillation period of the pulse light by the pulse laser 2 is equal to the period of the pulse current supplied to the magnetic sensor 100 by the current supply part 7. To additionally describe, the pulse light from the pulse laser 2 is synchronized with the rise in the pulse current supplied by the current supply part 7 to have a predetermined delay time T (refer to FIG. 5 to be described later) by using a synchronization device, such as an oscilloscope (not shown).

Moreover, it is preferable that the pulse width of the pulse light by the pulse laser 2 is sufficiently small as compared to the pulse width of the pulse current supplied to the magnetic sensor 100 by the current supply part 7. The pulse width of the pulse light from the pulse laser 2 can be set within the range of, for example, 0.5 ns to 20 ns though it may differ depending on the pulse width of the pulse current by the current supply part 7.

The pulse laser 2 is not particularly limited, and a solid-state laser capable of pulse oscillation (for example, an Nd-YAG laser), a gas laser (for example, a CO₂ laser), a semiconductor laser, or other lasers can be used.

The polarizer 3 linearly polarizes the pulse light emitted from the pulse laser 2 to have a predetermined polarized surface. Note that, in the case where a laser emitting linearly polarized light is used as the pulse laser 2, the magnetization measurement device 1 does not have to include the polarizer 3.

In the exemplary embodiment, the pulse laser 2 and the polarizer 3 constitute a light irradiation part that irradiates the surface of the magnetic sensor 100 (the sensitive element 31) with the pulse light having a predetermined polarized surface.

The analyzer 5 passes light having a specific polarized surface, from among the reflected light of the pulse light emitted from the pulse laser 2 and reflected on the surface of the sensitive element 31, toward the detection device 4. The polarized surface of the light passing through the analyzer 5 can be, for example, in a direction perpendicular to the polarized surface of light passing through the polarizer 3. In this case, the intensity of the light (the light quantity) passing through the analyzer 5 corresponds to the rotation angle of the polarized surface rotated on the surface of the sensitive element 31 by the magneto-optical Kerr effect.

The detection device 4 is an example of a measurement part and detects the light quantity of the reflected light passed through the analyzer 5 and measures the magnetization on the surface of the sensitive element 31 based on the detection results. As the detection device 4, for example, a charge coupled device (CCD) camera detecting the light quantity of the reflected light can be used. In addition, the detection device 4 may detect the angle of the polarized surface of the reflected light, to thereby measure the magnetization on the surface of the sensitive element 31 based on the detection results. In this case, the magnetization measurement device 1 does not have to include the analyzer 5.

Note that the method of measuring the magnetization on the surface of the sensitive element 31 by the detection device 4 will be described in detail later.

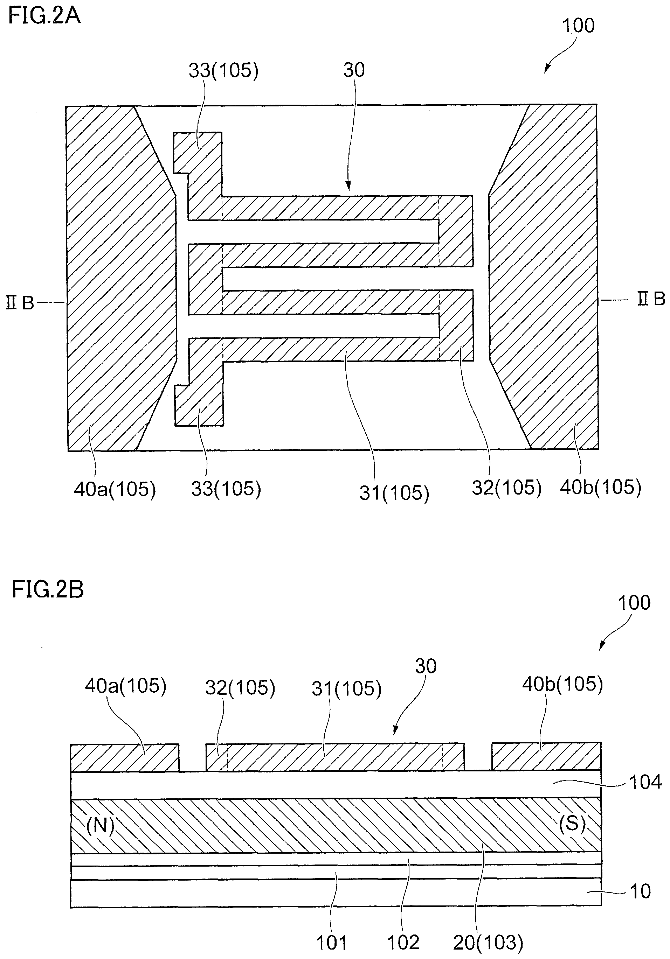

The current supply part 7 is configured with a circuit with a power supply and a pulse generator, etc., for example, and is connected to terminal parts 33 (refer to FIG. 2A to be described later) of the magnetic sensor 100. Then, the current supply part 7 supplies a pulse current with a predetermined pulse width to the magnetic sensor 100 at a predetermined period.

The pulse width of the pulse current supplied by the current supply part 7 can be set at, for example, 20 ns to 200 ns. In addition, the repetition period of the pulse current supplied by the current supply part 7 can be set at, for example, 1 MHz to 50 MHz.

Note that, other than the components shown in FIG. 1, the magnetization measurement device 1 may include optical components, such as a mirror reflecting the pulse light emitted from the pulse laser 2, the reflected light reflected by the surface of the magnetic sensor 100, etc., a lens condensing the light on the surface of the sensitive element 31, and the like.

### (Configuration of magnetic sensor 100)

Subsequently, the magnetic sensor 100, which is a sample for measuring change in the magnetization by the magnetization measurement device 1 of the exemplary embodiment, will be described. FIGS. 2A and 2B are diagrams illustrating an example of the configuration of the magnetic sensor 100. FIG. 2A is a plan view and FIG. 2B is a cross-sectional view along the IIB-IIB line in FIG. 2A.

As shown in FIG. 2B, the magnetic sensor 100 includes: a thin film magnet 20 configured with a hard magnetic material (a hard magnetic material layer 103) provided on a non-magnetic substrate 10; and a sensitive part 30 laminated to face the thin film magnet 20 and configured with a soft magnetic material (a soft magnetic material layer 105) to sense a magnetic field.

Here, the hard magnetic material has a large, so-called coercive force, the hard magnetic material being once magnetized by an external magnetic field, even upon removal of the external magnetic field, maintaining the magnetized state. On the other hand, the soft magnetic material has a small, so-called coercive force, the soft magnetic material being easily magnetized by an external magnetic field, but, upon removal of the external magnetic field, quickly returning to a state with no magnetization or a little magnetization.

Note that, in the present specification, an element constituting the magnetic sensor 100 is indicated by a two-digit number, and a layer processed into an element (the hard magnetic material layer 103 or the like) is indicated by a number of one hundreds. Then, for a figure indicating an element, a figure indicating a layer processed into the element is written in parentheses. For example, the case of the thin film magnet 20 is written as thin film magnet 20 (hard magnetic material layer 103). In the figure, the case is written as 20 (103). The same is true in other cases.

Description will be given of a planar structure of the magnetic sensor 100 by FIG. 2A. The magnetic sensor 100 has a quadrangular planar shape as an example. Here, the sensitive part 30 and yokes 40 formed at the uppermost portion of the magnetic sensor 100 will be described. The sensitive part 30 includes: plural reed-shaped sensitive elements 31 each having a longitudinal direction and a short direction in a planar shape thereof; connection parts 32 windingly performing serial connection of the adjacent sensitive elements 31; and terminal parts 33 to which electric wires are connected. Here, four sensitive elements 31 are arranged so that the longitudinal directions thereof are in parallel with one another. The sensitive element 31 serves as a magneto-impedance effect element.

The connection part 32 is provided between end portions of the adjacent sensitive elements 31 and windingly performs serial connection of the adjacent sensitive elements 31. In the magnetic sensor 100 shown in FIG. 2A, four sensitive elements 31 are disposed in parallel, and therefore there are three connection parts 32.

The terminal parts 33 are provided to the (two) respective end portions of the sensitive parts 31, the end portions not being connected to the connection parts 32. The terminal part 33 may have a size capable of connecting the electric wires. In the exemplary embodiment, in the case where the magnetization of the sensitive element 31 is measured by the magnetization measurement device 1 (refer to FIG. 1), the current supply part 7 is connected to the terminal parts 33 via the electric wires.

Then, the sensitive elements 31, the connection parts 32 and the terminal parts 33 of the sensitive part 30 are integrally constituted by a single layer of the soft magnetic material layer 105. The soft magnetic material layer 105 has conductivity, and therefore, when the pulse current is supplied from the current supply part 7, the pulse current flows from one terminal part 33 to the other terminal part 33.

Further, the magnetic sensor 100 includes two yokes 40a and 40b, each of which is provided to face each of both end portions of the sensitive elements 31 in the longitudinal direction thereof. Note that, in the case where the yokes 40a and 40b are not distinguished, the yokes are referred to as yokes 40. The yoke 40 guides magnetic force lines to the end portion of the sensitive element 31 in the longitudinal direction thereof. Therefore, the yokes 40 are constituted by a soft magnetic material (the soft magnetic material layer 105) through which the magnetic force lines are likely to pass. In other words, the sensitive part 30 and the yokes 40 are formed of a single layer of the soft magnetic material layer 105.

Next, with reference to FIG. 2B, the cross-sectional structure of the magnetic sensor 100 will be described. The magnetic sensor 100 is configured by laminating a hard magnetic material layer 103 (the thin film magnet 20), a dielectric layer 104 and the soft magnetic material layer 105 (the sensitive part 30 and the yokes 40) in this order on the non-magnetic substrate 10. In addition, the magnetic sensor 100 may include, between the substrate 10 and the hard magnetic material layer 103, a control layer 101 controlling the thin film magnet 20 to easily express magnetic anisotropy in an in-plane direction, and an adhesive layer 102 improving adhesiveness between the substrate 10 and the control layer 101.

The substrate 10 is composed of a non-magnetic material; for example, an oxide substrate, such as glass or sapphire, a semiconductor substrate, such as silicon, or a metal substrate, such as aluminum, stainless steel, or a nickel-phosphorus-plated metal, can be provided.

The hard magnetic material layer 103 constituting the thin film magnet 20 is composed of, for example, an alloy that contains Co as a main component and also contains at least one of Cr and Pt (hereinafter, referred to as a Co alloy constituting the thin film magnet 20). Examples of the Co alloy constituting the thin film magnet 20 include CoCrPt, CoCrTa, CoNiCr and CoCrPtB. Note that Fe may be contained. The hard magnetic material layer 103 is polycrystalline composed of a set of different crystal orientations, and each crystal has the magnetic anisotropy in the in-plane direction. The magnetic anisotropy is derived from crystal magnetic anisotropy.

The dielectric layer 104 is configured with a nonmagnetic dielectric material and electrically insulates the thin film magnet 20 and the sensitive part 30. Specific examples of the dielectric material constituting the dielectric layer 104 include oxide, such as SiO₂, Al₂O₃, or TiO₂, or nitride, such as Si₃N₄ or AlN.

The sensitive element 31 in the sensitive part 30 is provided with uniaxial magnetic anisotropy in a direction crossing the longitudinal direction, for example, an intersecting short direction. Note that the direction crossing the longitudinal direction may have an angle exceeding 45° with respect to the longitudinal direction. In the exemplary embodiment, the direction crossing the longitudinal direction corresponds to a first direction.

As the soft magnetic material layer 105 constituting the sensitive element 31, it is preferable to use an amorphous alloy, which is an alloy containing Co as a main component doped with a high melting point metal, such as Nb, Ta or W (hereinafter, referred to as a Co alloy constituting the sensitive element 31). Examples of the Co alloy constituting the sensitive element 31 include CoNbZr, CoFeTa and CoWZr.

The hard magnetic material layer 103 and the dielectric layer 104 are processed to have a quadrangular planar shape (refer to FIG. 2). Then, of the exposed side surfaces, in the two facing side surfaces, the thin film magnet 20 serves as the north pole ((N) in FIG. 2B) and the south pole ((S) in FIG. 2B). Note that the line connecting the north pole and the south pole of the thin film magnet 20 takes the longitudinal direction of the sensitive element 31 in the sensitive part 30. Here, to take the longitudinal direction means that an angle formed by the line connecting the north pole and the south pole and the longitudinal direction is less than 45°.

In the magnetic sensor 100, the lines of magnetic force outputted from the north pole of the thin film magnet 20 once go to the outside of the magnetic sensor 100. Then, a part of the lines of magnetic force passes through the sensitive element 31 via the yoke 40a and goes to the outside again via the yoke 40b. The magnetic force lines that have passed through the sensitive element 31 return to the south pole of the thin film magnet 20 together with the magnetic force lines that have not passed through the sensitive element 31. In other words, the thin film magnet 20 applies the magnetic field (a bias magnetic field) to the longitudinal direction of the sensitive element 31. In the exemplary embodiment, the longitudinal direction corresponds to a second direction.

### (Characteristics of magnetic sensor 100)

Subsequently, characteristics of the magnetic sensor 100 will be described. In the magnetic sensor 100 shown in FIGS. 2A and 2B, change occurs in the voltage when the pulse current is supplied by the current supply part 7. In addition, the amount of change in the voltage caused in the magnetic sensor 100 due to the supply of the pulse current differs depending on the magnitude of the magnetic field H applied to the sensitive element 31 of the magnetic sensor 100.

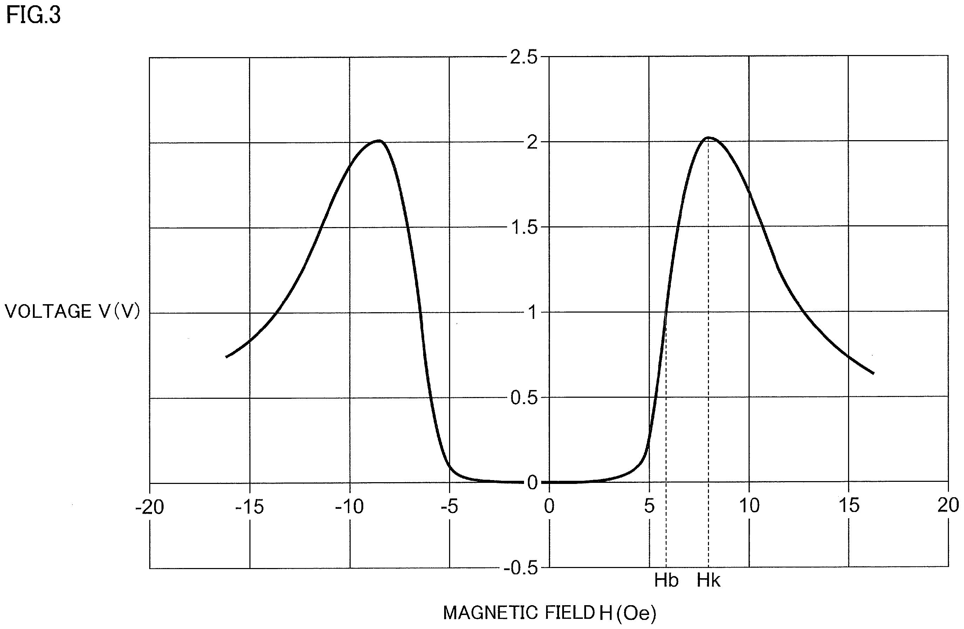

FIG. 3 is a diagram showing a relation between the magnetic field applied in the longitudinal direction of the sensitive element 31 and the change in the voltage generated in the magnetic sensor 100 when the pulse current is supplied to the magnetic sensor 100 by the current supply part 7. FIG. 3 is obtained by supplying the pulsed current to the magnetic sensor 100 from the current supply part 7, and by measuring the change in the voltage V outputted from the magnetic sensor 100 by a not-shown voltage measurement device. In FIG. 3, the horizontal axis indicates the magnetic field H (Oe), and the vertical axis indicates the voltage V (V). In this example, as the voltage V, the peak value of the overshoot voltage outputted from the magnetic sensor 1 when the pulse current is supplied.

As shown in FIG. 3, the voltage V of the magnetic sensor 1 is changed, increased, or decreased, as the absolute value of the magnetic field H increases in the positive direction or the negative direction, with a boundary of the magnetic field H being 0 (H = 0). Moreover, the amount of change in the voltage V (in other words, the slope of the graph) in relation to the amount of change in the magnetic field H differs depending on the magnitude of the magnetic field H.

Consequently, in the magnetic sensor 100, by use of a portion where the amount of change ΔV in the voltage V with respect to the amount of change ΔH in the magnetic field H to be applied is steep (in other words, the portion where ΔV/ΔH is large), it is possible to extract extremely weak change in the magnetic field H as the amount of change ΔV in the voltage V. In FIG. 3, the magnetic field H, where the amount of change ΔV of the voltage V to the amount of change ΔH of the magnetic field H (ΔV/ΔH) is the maximum, is shown as the magnetic field Hb. In the magnetic sensor 100, it is possible to measure the amount of change ΔH of the magnetic field H in the vicinity of the magnetic field Hb with high accuracy. The magnetic field Hb is sometimes referred to as a bias magnetic field, and, in the magnetic sensor 100, the bias magnetic field Hb is applied in the longitudinal direction of the sensitive element 31 by the thin film magnet 20. In addition, in the following description, the magnetic field H, where the voltage V of the magnetic sensor 1 takes the maximum value, is referred to as an anisotropic magnetic field Hk in some cases.

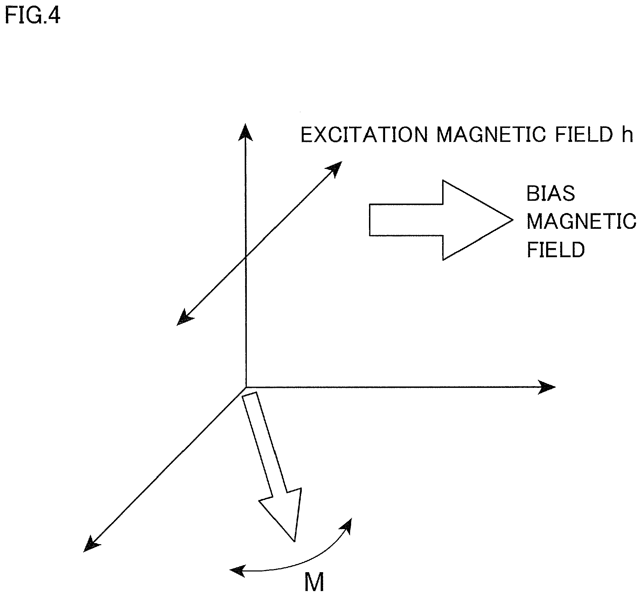

FIG. 4 is a schematic view showing change in the magnetization of the sensitive element 31 in the case where the pulse current is supplied.

When the pulse current is supplied to the magnetic sensor 100, as shown in FIG. 4, the excitation magnetic field h is generated in the short direction of the sensitive element 31. It is estimated that the excitation magnetic field h causes the magnetic moment of the sensitive element 31 to move in response to supply of the pulse current, and thereby the magnetization M of the sensitive element 31 changes.

According to the magnetization measurement device 1 of the exemplary embodiment, it is possible to measure the change in the magnetization M of the sensitive element 31 in response to the supply of the pulse current over time.

### (Magnetization measurement method by magnetization measurement device 1)

Subsequently, description will be given of the measurement method of the magnetization of the magnetic sensor 100 (the sensitive element 31) by the magnetization measurement device 1.

FIG. 5 is a timing chart showing a relation between the pulse current supplied to the magnetic sensor 100 by the current supply part 7 and pulse light emitted to the surface of the sensitive element 31 in the magnetic sensor 100 by the pulse laser 2.

As described above, the magnetization measurement device 1 supplies the pulse current to the magnetic sensor 100 via the terminal parts 33 at a predetermined repetition period by the current supply part 7. Consequently, the pulse current flows along the longitudinal direction in the sensitive element 31 of the magnetic sensor 100.

In addition, the magnetization measurement device 1 irradiates the surface of the sensitive element 31 in the magnetic sensor 100 with the pulse light by the pulse laser 2. As shown in FIG. 5, the pulse laser 2 emits the pulse light in synchronization with the period of the pulse current to have a predetermined delay time T with respect to the rise in the pulse current supplied by the current supply part 7.

The pulse light emitted from the pulse laser 2 is, as described above, linearly polarized by the polarizer 3 to have a predetermined polarized surface. Then, the linearly polarized pulse light enters the surface of the sensitive element 31 after the pulse current was supplied to the sensitive element 31 and after the delay time T has elapsed.

Here, in the exemplary embodiment, the sensitive element 31 is irradiated with the pulse light so that the advancing direction of the pulse light that is to enter the surface of the sensitive element 31 and the advancing direction of the reflected light reflected by the surface of the sensitive element 31 are in parallel with the short direction of the sensitive element 31. In the exemplary embodiment, the advancing direction of the pulse light that is to enter the surface of the sensitive element 31 and the advancing direction of the reflected light reflected by the surface of the sensitive element 31 that are in parallel with the short direction of the sensitive element 31 (the direction perpendicular to the direction in which the bias magnetic field Hb is applied) make it possible to detect the reflected light with a polarized surface rotated by the longitudinal Kerr effect by use of the detection device 4.

Note that, in the description of the exemplary embodiment, the advancing direction of the pulse light and the advancing direction of the reflected light being in parallel with the short direction of the sensitive element 31 mean that the advancing directions of the pulse light and the reflected light projected onto the surface of the sensitive element 31 are the same as the short direction of the sensitive element 31. The advancing direction of the pulse light can be controlled by an optical member, such as a not-shown reflecting mirror, for example.

By the surface of the sensitive element 31, the pulse light is reflected. In the reflected light of the pulse light, in response to the magnetization M of the sensitive element 31, the polarized surface is rotated by the magneto-optical Kerr effect (in this example, by the longitudinal Kerr effect). Then, the reflected light passes through the analyzer 5 and enters the detection device 4.

The detection device 4 detects the intensity (the light quantity) of the reflected light that has passed through the analyzer 5 and has entered, and based on the result, measures the magnetization M on the surface of the sensitive element 31 at the delay time T.

As described above, the polarized surface of the light passing through the analyzer 5 is perpendicular to the polarized surface of the light passing through the polarizer 3. In this case, the intensity (the light quantity) of the reflected light passing through the analyzer 5 and entering the detection device 4 corresponds to the rotation angle of the polarized surface of the reflected light rotated on the surface of the sensitive element 31 by the magneto-optical Kerr effect. In addition, the rotation angle of the polarized surface of the reflected light rotated on the surface of the sensitive element 31 corresponds to the state of the magnetization M on the surface of the sensitive element 31.

Consequently, the detection device 4 detects the intensity (the light quantity) of the reflected light, and based on the result, it is possible to obtain the magnetization M on the surface of the sensitive element 31. To additionally describe, the detection device 4 can measure the magnetization M on the surface of the sensitive element 31 after the delay time T has elapsed since the rise of the pulse current based on the reflected light.

Moreover, the magnetization measurement device 1 measures the magnetization M with slightly different delay times T for irradiating the sensitive element 31 with the pulse light and combines the measurement results of the magnetization M at the respective delay times T, and thereby the change in the magnetization M over time in response to the supply of the pulse current.

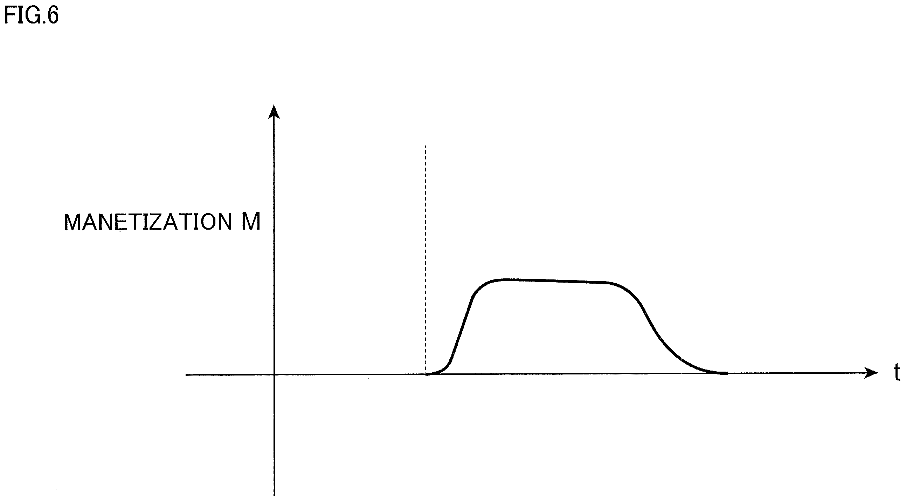

FIG. 6 is a diagram showing an example of the change in the magnetization M in the sensitive element 31 over time, which is obtained by combining the measurement results of the magnetization M measured with different delay times T of the pulse light. Note that FIG. 6 is merely an example for description and is not necessarily accurate. In addition, FIG. 6 shows the timing of supplying the pulse current to the magnetic sensor 100 by the current supply part 7 by the broken line.

As shown in FIG. 6, the magnetization measurement device 1 of the exemplary embodiment can confirm how the magnetization M of the sensitive element 31 changes with respect to the timing of supplying the pulse current to the magnetic sensor 100 (for example, the rise and the fall of the pulse current).

Note that, in the magnetization measurement device 1, in the case where the change in the magnetization M over time is obtained by measuring the magnetization M with the different delay times T and combining the measurement results, it is preferable to measure the magnetization M plural times for each delay time T and adopt the average value of the plural measurement results. By measuring the magnetization M plural times for each delay time T, it is possible to reduce the error in the measurement results at each delay time T.

As described so far, according to the magnetization measurement device 1 of the exemplary embodiment, it becomes possible to measure the change in the magnetization M over time, which occurs in the sensitive element 31 when the current periodically changes, such as the pulse current, is supplied to the magnetic sensor 100.

Note that, in the exemplary embodiment, the current supply part 7 supplies, as the periodically changing current to be supplied, the pulse current with a predetermined repetition period to the magnetic sensor 100; however, the periodically changing current is not limited thereto. As the periodically changing current, the current supply part 7 may supply a high-frequency current with a predetermined frequency, for example. In this case, the magnetization measurement device 1 measures the magnetization M with different delay times T in relation to a specific phase of the high-frequency current, and thereby it is possible to confirm how the magnetization M of the sensitive element 31 changes with respect to the phase of the high-frequency current.

In addition, in the exemplary embodiment, the sensitive element 31 is irradiated with the pulse light from the pulse laser 2 so that the advancing direction of the pulse light to enter the surface of the sensitive element 31 and the advancing direction of the reflected light reflected by the surface of the sensitive element 31 are in parallel with the short direction of the sensitive element 31; however, irradiation is not limited thereto. For example, pulse light irradiation by the pulse laser 2 may be performed so that the advancing direction of the pulse light to enter the surface of the sensitive element 31 and the advancing direction of the reflected light reflected by the surface of the sensitive element 31 are in parallel with the longitudinal direction of the sensitive element 31.

Further, in the exemplary embodiment, the sensitive element 31 of the magnetic sensor 100 is taken as an example of an object (the sample) of measuring the magnetization M by the magnetization measurement device 1, but the object of measuring is not limited thereto. The object of measuring the magnetization M by the magnetization measurement device 1 is not particularly limited as long as the object is a soft magnetic material with uniaxial magnetic anisotropy in a predetermined first direction and a bias magnetic field applied in a second direction crossing the first direction. In addition, the configuration of applying the bias magnetic field to the soft magnetic material, which is the object of measuring, may be integrated with the object of measuring (the sensitive element 31), such as the thin film magnet 20 of the magnetic sensor 100, or may be separated from the object of measuring.

### Reference Signs List

1 Magnetization measurement device
2 Pulse laser
3 Polarizer
4 Detection device
5 Analyzer
7 Current supply part
20 Thin film magnet
30 Sensitive part
31 Sensitive element
100 Magnetic sensor

## Claims

1. A magnetization measurement device comprising:
a current supply part supplying a periodically changing current to a sample made of a soft magnetic material with uniaxial magnetic anisotropy in a predetermined first direction and a bias magnetic field applied in a second direction crossing the first direction;
a light irradiation part irradiating a surface of the sample with linearly polarized pulse light having a predetermined delay time with respect to the current and having a predetermined polarized surface; and
a measurement part measuring magnetization of the sample at the delay time based on reflected light of the pulse light reflected by the surface of the sample.

2. The magnetization measurement device according to claim 1, wherein the current supply part supplies a pulse current having a predetermined repetition period to the sample.

3. The magnetization measurement device according to claim 1 or 2, wherein the light irradiation part emits the pulse light to cause an advancing direction of the pulse light that is to enter the sample and an advancing direction of the reflected light reflected by the surface of the sample to be in parallel with the first direction or the second direction.

4. A magnetization measurement method comprising:
supplying a periodically changing current to a sample made of a soft magnetic material with uniaxial magnetic anisotropy in a predetermined first direction and a bias magnetic field applied in a second direction crossing the first direction;
irradiating a surface of the sample with linearly polarized pulse light having a predetermined delay time with respect to the current and having a predetermined polarized surface; and
measuring magnetization of the sample at the delay time based on reflected light of the pulse light reflected by the surface of the sample.
